# EUROPEAN PATENT APPLICATION

(11) **EP 4 550 383 A1**
(43) Date of publication of application: **07.05.2025**
(21) Application number: 24204181.2
(22) Date of filing: 02.10.2024
(51) Int. Cl.: H01J 37/34, H01J 37/32, C23C 14/34

(54) **LOW TEMPERATURE DEPOSITION OF HYDROGEN-FREE DIAMOND-LIKE CARBON FILMS**

(30) Priority: 01.11.2023 US 202318499259
(71) Applicant: INTEL Corporation, Santa Clara, CA 95054 (US)
(72) Inventor: KARPOV, Ilya, Portland, 97229 (US); TRONIC, Tristan, Aloha, 97003 (US); SEN GUPTA, Arnab, Hillsboro, 97123 (US); WANG, Jin Jimmy, Castro Valley, 94546 (US); METZ, Matthew, Portland, 97229 (US); MATTSON, Eric, Portland, 97225 (US); TUNG, I-Cheng, Hillsboro (US)
(74) Representative: Viering, Jentschura & Partner mbB Patent- und Rechtsanwälte

(57) **Abstract**

The present disclosure is directed to a high-voltage magnetron sputtering tool with an enhanced power source including a vacuum chamber containing a magnetron cathode with a magnet array, a target, and an anode, as well as the enhanced power source that includes high-power DC power source and controller that produces a pulsed output. In an aspect, the enhanced power source may include a standard power source that is retrofitted a supplemental high-power DC power source and controller, and alternatively, a high-power DC power source and controller that replaces the standard power source. In addition, the present disclosure is directed to methods for depositing a hydrogen-free diamond-like carbon film on a semiconductor substrate using the high-voltage magnetron sputtering tool. In an aspect, the hydrogen-free diamond-like carbon film may be an etch mask having a sp3 carbon bonding that is greater than 60 percent.

## Description

### Background

For integrated circuit design and fabrication, the need to improve performance and lower costs are constant challenges. Etching is a critically important process step used in semiconductor fabrication as every wafer will undergo multiple etching steps before the integrated circuit design is completed.

For many of the typical etch steps, a part of the wafer is protected from the etchant by a "masking" material that resists etching. In some cases, the masking material is a photoresist that has been patterned using photolithography. In some situations, a more durable or hard mask is required, and for such a hard mask, the common masking materials that are used include silicon dioxide, silicon nitride, and silicon oxynitride.

A plasma-enhanced chemical vapor deposition (PECVD) process may used to form these hard masks. The PECVD process introduces reactant gases between parallel electrodes, i.e., a grounded electrode and an RF-energized electrode. The capacitive coupling between the electrodes excites the reactant gases into a plasma, which induces a chemical reaction and results in the reaction product being deposited onto a substrate.

Recently, diamond-like carbon (DLC) films, a type of amorphous carbon film that has a combination of sp³ and sp² bonds and has properties of both diamond and graphite, have been used as hard masks. These DLC film hard masks are fabricated by PECVD. Such DLC films may have a large hydrogen content, a relatively low percentage of sp3 bonding, and low density, and therefore, a reduced selectivity when used for etching.

### Brief Description of the Drawings

In the drawings, like reference characters generally refer to the same parts throughout the different views. The drawings are not necessarily to scale, emphasis instead generally being placed upon illustrating the principles of the present disclosure. The dimensions of the various features or elements may be arbitrarily expanded or reduced for clarity. In the following description, various aspects of the present disclosure are described with reference to the following drawings, in which:
FIG. 1 shows an exemplary representation of a magnetron sputtering tool;
FIG. 2 shows an exemplary representation of a high-voltage magnetron sputtering tool with an enhanced power source and FIG. 2A shows another exemplary representation of a high-voltage magnetron sputtering tool with a supplemental power source according to aspects of the present disclosure;
FIG. 3 shows another exemplary representation of a high-voltage magnetron sputtering tool with an enhanced power source according to another aspect of the present disclosure;
FIG. 4 shows additional exemplary test results for carbon layers formed according to an aspect of the present disclosure; and
FIG. 5 shows a simplified flow diagram for an exemplary method according to an aspect of the present disclosure.

### Detailed Description

The following detailed description refers to the accompanying drawings that show, by way of illustration, specific details, and aspects in which the present disclosure may be practiced. These aspects are described in sufficient detail to enable those skilled in the art to practice the present disclosure. Various aspects are provided for devices, and various aspects are provided for methods. It will be understood that the basic properties of the devices also hold for the methods and vice versa. Other aspects may be utilized and structural, and logical changes may be made without departing from the scope of the present disclosure. The various aspects are not necessarily mutually exclusive, as some aspects can be combined with one or more other aspects to form new aspects.

According to the present disclosure, a standard or conventional magnetron sputtering tool that is typically used for semiconductor manufacturing may be modified with a specialized, high-power voltage source to deposit DLC films with a very high percentage of sp₃ carbon bonding (e.g., with 60% or more sp3 carbon bonding) and containing little or no hydrogen. In an aspect, the present hydrogen-free DLC films may be deposited under low-temperature conditions (e.g., room temperature) when using this enhanced high-voltage magnetron sputtering tool. In addition, the present hydrogen DLC films offer exceptional etch selectivity as well as other useful properties.

The present disclosure provides a semiconductor tool including a vacuum chamber containing a magnetron cathode with a magnet array and a target, and an anode, as well as an enhanced power source with a controller to enable a high voltage of up to 1000V, a high current of 1 amp per cm², and a low duty cycle pulses as short as 5 µs, which is connected to the magnetron cathode/target. In another aspect, the semiconductor tool may have a high power source with a controller to enable high voltage of up to 1000V, a high current of 1 amp per cm², and a low duty cycle pulses as short as 5 µs, which is connected to a wafer chuck/anode. and synchronized with a standard power source or unit. In an aspect, the enhanced power source may include a standard power module and a supplemental high-power module, and alternatively, a retrofitted high-power DC power source.

The present disclosure is also directed to a method that includes providing a substrate with an electrical bias up to -300 V, a high-voltage magnetron sputtering tool with an enhanced power source, providing a carbon target, and setting operating conditions to deposit a hydrogen-free diamond-like carbon film on the substrate, which includes an operating temperature in a range of approximately 20 to 150 C°.

The present disclosure is further directed to an etch mask that is a diamond-like carbon film having a sp3 carbon bonding that is greater than 60 percent that is deposited by a high-voltage magnetron sputtering tool with an enhanced power source. In an aspect, the diamond-like carbon film may have a sp3 carbon bonding that is greater than 75 percent and a composition of hydrogen of 0 percent.

The technical advantages of the present disclosure include, but are not limited to:
(i) providing the ability to use retrofitted magnetron sputtering tools to form low-temperature hydrogen-free diamond-like carbon films;
(ii) providing diamond-like carbon films with higher selectivity and superior hardmask capability (i.e., etch resistant and high density); and
(iii) providing an improved low-temperature method for the deposition of diamond-like carbon films that reduces the contribution to the overall thermal budget.

To more readily understand and put into practical effect the present magnetron sputtering tool and methods, which may produce improved hydrogen-free, diamond-like carbon films, particular aspects will now be described by way of examples provided in the drawings that are not intended as limitations. The advantages and features of the aspects herein disclosed will be apparent through reference to the following descriptions relating to the accompanying drawings. Furthermore, it is to be understood that the features of the various aspects described herein are not mutually exclusive and can exist in various combinations and permutations. For the sake of brevity, duplicate descriptions of features and properties may be omitted.

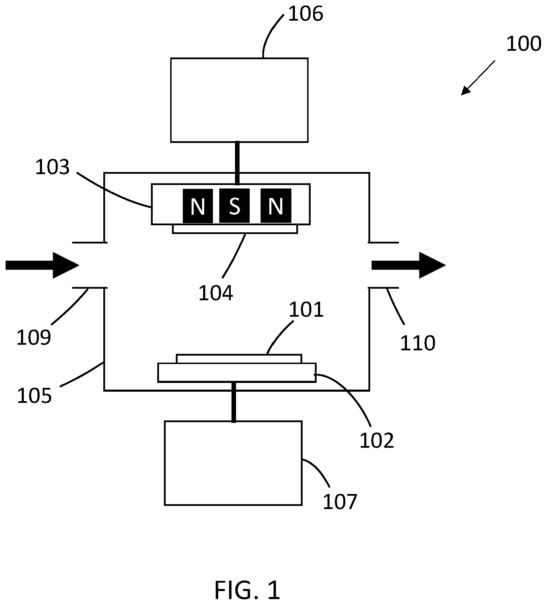

FIG. 1 shows an exemplary representation of a conventional magnetron sputtering tool 100 for forming a film. Magnetron sputtering deposition is a vacuum coating process that falls under the category of physical vapor deposition (PVD) and is mainly used for depositing metals, alloys, and other materials with a thickness of up to 100 nm. In FIG. 1, the magnetron sputtering tool 100 may include a rotating support 102, which may be a chuck for holding a wafer/substrate 101, a magnet unit 103 with a mounted target 104, and the rotating support 102 holding the wafer 101 and the magnet unit 103 with the target 104 are disposed in a vacuum chamber 105 with a gas inlet 109 and gas outlet 110. In an aspect, the magnet unit 103 may be a magnetron cathode with a magnet array and may be connected to a direct or pulsed DC power source, or alternatively, an RF power source 106, and the support 102 may act as an anode and may be connected to an RF power source 107.

Presently, the conventional magnetron sputtering tools being used in the semiconductor manufacturing industry are offered by, for example, Applied Material, Inc., Tokyo Electron Limited, ULVAC Technologies, Inc., and other manufacturers.

The basic mechanism of a magnetron sputtering coating process requires a target made of the material desired to be deposited to be placed in a vacuum chamber of a magnetron sputtering tool and bombarding the target with energetic ions of an inert gas (e.g., argon, krypton, or xenon). A high vacuum is needed in the vacuum chamber to create a low-pressure environment for the sputtering. The inert gas enters the vacuum chamber first and a high negative voltage is applied between a cathode and an anode to initiate the ionization of the inert gas. The forceful collision of these energetic ions with the target ejects target atoms into the vacuum chamber. A magnet array in the cathode of the magnetron sputtering tool creates a magnetic field to keep the plasma near the target to control the rate of deposition. These target atoms are then deposited on a substrate material placed on the anode in the vacuum chamber forming a film. The target is typically cooled by water so that little radiation heat is generated. A wide range of targets may be used, including copper, titanium, tantalum, tungsten, and carbon.

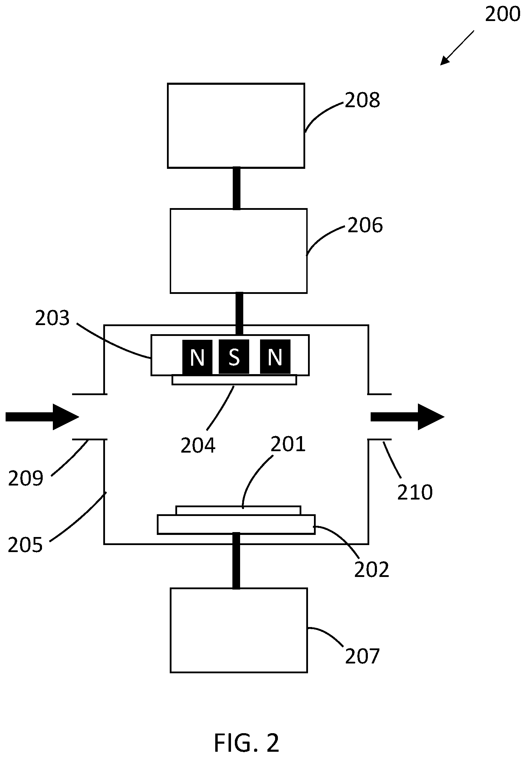

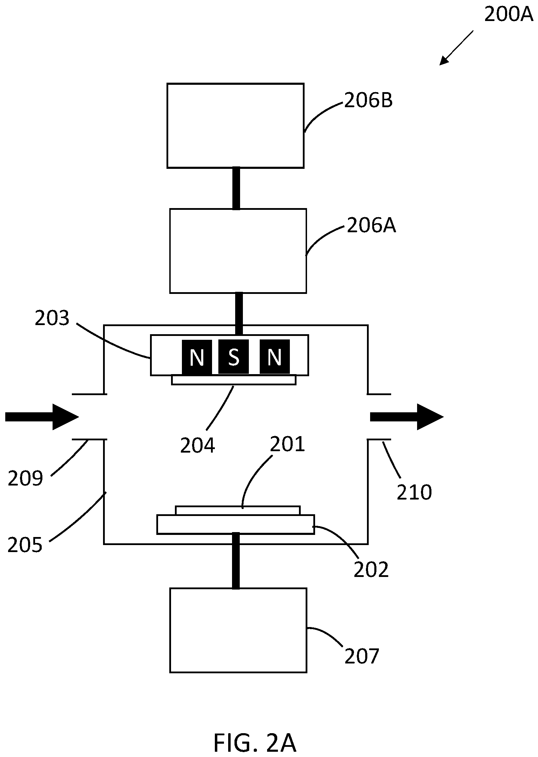

FIG. 2 shows an exemplary representation of an enhanced high-voltage magnetron sputtering tool 200 according to an aspect of the present disclosure. The magnetron sputtering tool 200 includes a support 202, which may be a chuck or rotating support for holding a wafer/substrate 201, a magnet unit 203 with a mounted target 204, and the rotating support 202 holding the wafer 201 and the magnet unit 203 with the target 204 are disposed in a vacuum chamber 205 with a gas inlet 209 and gas outlet 210, which are components found in a standard or conventional magnetron sputtering tool. In an aspect, the magnet unit 203, which has an array of magnets, may act as a cathode and be connected to a first DC power source 206 and a controller 208, which together provide an enhanced high voltage pulsed DC power source of up to 1000 volts, a high current of 1 amp per cm², and a low duty cycle pulses as short as 5 µs, which is connected to the magnetron cathode/target. The controller 208 acts to "shape" the output of DC power source 206 into pulses for specific requirements. The support 202, which may be a wafer chuck, may act as an anode and may be connected to a second power source 207 to provide the support/anode 202 with a negative bias. In an aspect, the enhanced high-voltage magnetron sputtering tool 200 may be operated at approximately room temperature or moderately low temperature (e.g., in a range of 20 to 150 C°).

In an aspect, the DC power source 206 and controller 208 may be configured to provide, for example, an output power in a range of approximately 6 to 15 kW, a peak current in a range of approximately 400 to 2kA with a peak current equal to a current density of 0.5 to 1A per cm² times the target area, and as pulses having a pulse frequency in a range of approximately 10 to 100 kHz with short current pulse duration in a range of approximately 10 to 100 µs. The operating conditions to deposit and form hydrogen-free, diamond-like carbon films may be provided by a control unit (not shown) coupled to the enhanced high-voltage magnetron sputtering tool 200.

In another aspect, the present enhanced high-voltage magnetron sputtering tool 200 may be a new tool that is purposed to form DLC films. In another aspect, the DC power source 206 and controller 208 may be a single unit or "box" (not shown), that provides an enhanced power source, i.e., a high-power pulsed DC power source, that may be retrofitted into an existing conventional magnetron sputtering tool by removing its standard power source and replacing it with the present enhanced power source.

As shown in FIG. 2A, a present enhanced high-voltage magnetron sputtering tool 200A may be configured by providing a supplemental high-power unit with an integrated controller 206B that enhances the output of a standard power source 206A of an existing conventional magnetron sputtering tool to obtain the power output set forth herein.

In a further aspect, the enhanced power supply may have an output power and current that depends on the target size, which may have a current density of greater than 0.5A per cm² delivered in a very short pulse time. This is a very high current compared with any conventional power supply in any state-of-the-art magnetron sputtering tool. In an aspect, for a target size greater than 300 mm, the requirement for the power source capability may be a power (P) equal to 10 kW, a voltage (V) equal to 1 kV, and a current (I) equal to 1 kA. In another aspect, for a target size less than 150 mm, the requirements for the power source capability may be a P less than 6 kW, a V equal to 1 kV, and an I equal to 600 A. In another aspect, the enhanced power source may have a pulse frequency in the range of approximately 1-10 kHz and a pulse duration of 2 to 1000 µs.

DLC films are made of carbon, but they have a combination of sp2 and sp3 bonds. As a result, a DLC film has a combination of the properties of both diamond and graphite; for example, it can be very hard but also have very low friction. The DLC films currently used in semiconductor manufacturing are typically fabricated by plasma-enhanced chemical vapor deposition (PECVD), and these DLC films have a high hydrogen content, a relatively low percentage of sp₃ carbon bonding, and a relatively low density, and therefore, poor selectivity. In addition, a substrate to be coated may need to be heated to 350 C° at a mid-pressure of 1 Torr.

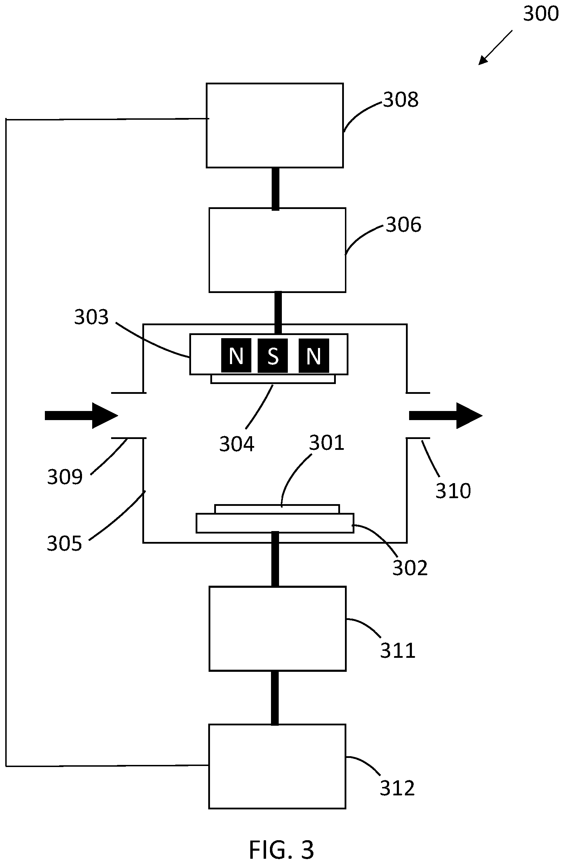

FIG. 3 shows an exemplary representation of an enhanced high-voltage magnetron sputtering tool 300 according to an aspect of the present disclosure. The magnetron sputtering tool 300 includes a rotating support 302, which may be a chuck for holding a wafer/substrate 301, a magnet unit 303 with a mounted target 304, and the rotating support 302 holding the wafer 301 and the magnet unit 303 with the target 304 are disposed in a vacuum chamber 305 with a gas inlet 309 and gas outlet 310, which are components found in a standard or conventional magnetron sputtering tool. In an aspect, the magnet unit 303, which has an array of magnets, may act as a cathode and be connected to a first DC power source 306 and a controller 308, which together provide an enhanced high voltage pulsed DC power source of up to 1000 volts, a high current of 1 amp per cm², and a low duty cycle pulses as short as 5 µs, which is connected to the magnetron cathode/target. The controller 308 acts to "shape" the output of DC power source 306 into pulses for specific requirements. The support 302, which may be a wafer chuck, may act as an anode and may be connected to a second DC power source 311 and a controller 312 to provide the support/anode 302 with a negative bias in place of an RF power source. The second DC power source 311 and the controller 312 may be synchronized with the first DC power source 306 and the controller 308.

According to the present disclosure, the present diamond-like carbon (DLC) films have up to 80 percent of sp3 carbon bonding, and hydrogen-free may be produced by the present enhanced high-voltage magnetron sputtering tool. In an aspect, for example, the present DLC film-1 may have a sp³ carbon bonding that is greater than approximately 60 percent, and the present DLC film-2 may have a sp³ carbon bonding that is greater than approximately 75 percent and a composition of hydrogen of approximately 0 percent. In another aspect, the present DLC films may have a high density as shown in Table 1 below:

**TABLE 1**

| | Type | Mass density (gm/cm³) |
|---|---|---|
| 1. | Conventional DLC | <2 |
| 2. | New DLC-1 | 2.4 |
| 3. | New DLC-2 | 2.8 |

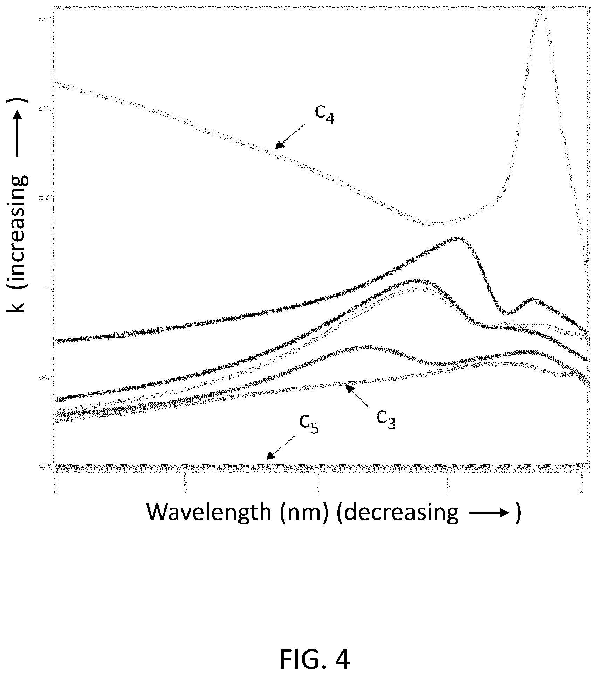

FIG. 4 shows exemplary test results for DLC films formed according to aspects of the present disclosure using a present enhanced high-power magnetron sputtering tool. In an aspect shown in FIG. 4, the use of spectral ellipsometry may be used to provide optical measurements for various carbon films. A curve for an optimized DLC film, shown as curve c₃, indicates that most of this film consists of sp3 carbon bonds. The present DLC films with a high percentage of sp3 bonding look non-metallic and have nearly non-measurable resistance, whereas carbon films with mostly sp2 bonds look metallic and have measurable resistances. In addition, a curve for a graphite film, shown as curve c₄, indicates that very little of this film consists of sp3 carbon bonds. Also shown in FIG. 4, the extinction coefficient k shows an increasing value as wavelength decreases for curve c₃, whereas the opposite is seen with graphite in curve c₄. By comparison, a diamond's k value is approximately zero until deep in the UV wavelengths, as shown in curve cs.

According to the present disclosure, the etch selectivity properties of the present DLC films may greatly improve as compared with conventional masks made of silicon oxide (SiO₂) and silicon nitride (Si₃N₄) films.

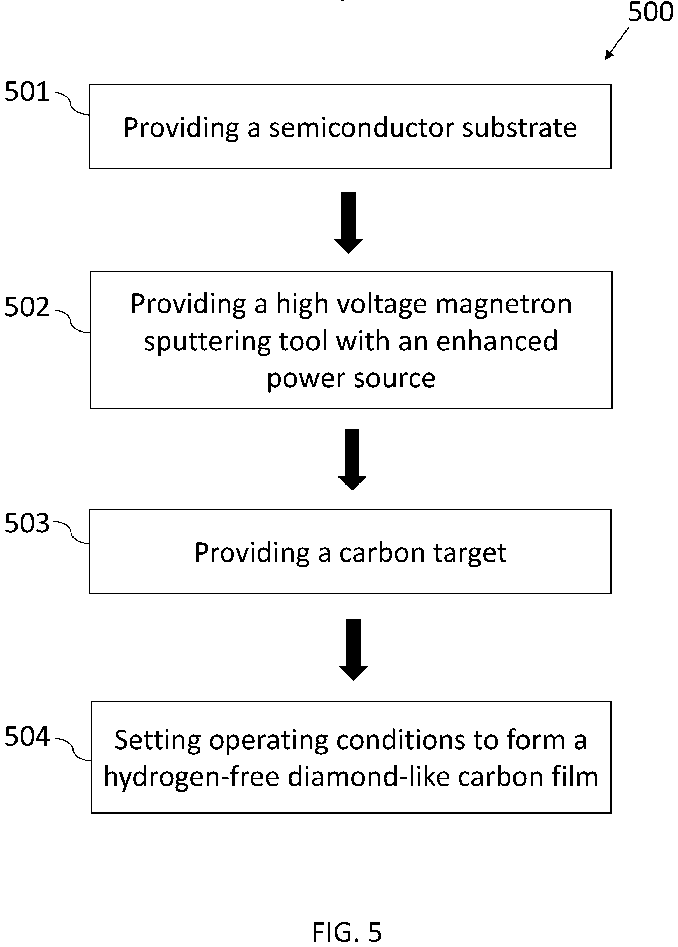

FIG. 5 shows a simplified flow diagram for an exemplary method 500 according to an aspect of the present disclosure.

The operation 501 may be directed to providing a semiconductor substrate.

The operation 502 may be directed to providing a high-voltage magnetron sputtering tool with an enhanced power source.

The operation 503 may be directed to providing a carbon target.

The operation 504 may be directed to setting operating conditions to form a hydrogen-free diamond-like carbon film.

It will be understood that any property described herein for a particular enhanced power magnetron sputtering tool and method for producing a particular DLC film may also hold for any DLC film using the present enhanced power magnetron sputtering tool described herein. It will also be understood that any property described herein for a specific method may hold for any of the methods described herein. Furthermore, it will be understood that for any enhanced power magnetron sputtering tool and the methods described herein, not necessarily all the components or operations described will be shown in the accompanying drawings or method, but only some (not all) components or operations may be disclosed.

To more readily understand and put into practical effect the present enhanced power magnetron sputtering tool and method, they will now be described by way of examples. For the sake of brevity, duplicate descriptions of features and properties may be omitted.

### Examples

Example 1 provides a semiconductor tool including a vacuum chamber, a magnetron cathode including a magnet array, a target, and an anode, for which the magnetron cathode, the target, and the anode are disposed within the vacuum chamber, an enhanced power source that is coupled to the magnetron cathode, and a second power source that is coupled to the anode.

Example 2 may include the semiconductor tool of example 1 and/or any other example disclosed herein, for which the enhanced power source includes a standard power source and a supplemental high-power DC power source with a controller that produces a pulsed output.

Example 3 may include the semiconductor tool of example 1 and/or any other example disclosed herein, for which the enhanced power source includes a high-power DC power source with a controller that produces a pulsed output.

Example 4 may include the semiconductor tool of example 1 and/or any other example disclosed herein, for which the second power source comprises an RF power source or a high-power DC power source with a controller that produces a pulsed output.

Example 5 may include the semiconductor tool of example 1 and/or any other example disclosed herein, for which the enhanced power source provides a voltage output in a range of approximately 6 to 15 kilowatts.

Example 6 may include the semiconductor tool of example 1 and/or any other example disclosed herein, for which the enhanced power source provides a peak current in a range of approximately 400 to 2000 amps.

Example 7 may include the semiconductor tool of example 5 and/or any other example disclosed herein, for which the enhanced power source provides a peak current density in a range of approximately 0.5 to 1A per cm2.

Example 8 may include the semiconductor tool of example 1 and/or any other example disclosed herein, for which the enhanced power source provides output pulses having a pulse frequency in a range of approximately 10 to 100 kHz.

Example 9 may include the semiconductor tool of example 7 and/or any other example disclosed herein, for which the enhanced power source provides output pulses having a high current pulse duration in a range of approximately 10 to 100 µs.

Example 10 may include the semiconductor tool of example 1 and/or any other example disclosed herein, for which the target includes a carbon material.

Example 11 may include the semiconductor tool of example 1 and/or any other example disclosed herein, for which the anode includes a support or chuck for a semiconductor wafer.

Example 12 provides a method that includes providing a substrate, providing a high-voltage magnetron sputtering tool including an enhanced power source, providing a carbon target, and setting operating conditions to deposit a hydrogen-free diamond-like carbon film on the substrate.

Example 13 may include the method of example 12 and/or any other example disclosed herein, for which the operating conditions comprise an operating temperature in a range of approximately 20 to 150 C°.

Example 14 may include the method of example 12 and/or any other example disclosed herein, for which the operating conditions comprise the enhanced power source providing a voltage output in a range of approximately 6 to 15 kilowatts.

Example 15 may include the method of example 12 and/or any other example disclosed herein, for which the operating conditions comprise the enhanced power source providing a peak current in a range of approximately 400 to 2000 amps.

Example 16 may include the method of example 15 and/or any other example disclosed herein, for which the operating conditions comprise the enhanced power source providing a peak current density in a range of approximately 0.5 to 1A per cm2.

Example 17 may include the method of example 12 and/or any other example disclosed herein, for which the operating conditions comprise the enhanced power source providing a pulse frequency in a range of approximately 10 to 100 kHz.

Example 18 may include the method of example 17 and/or any other example disclosed herein, for which the operating conditions comprise the enhanced power source providing a high current pulse duration in a range of approximately 10 to 100 µs.

Example 19 provides an etch mask that includes a diamond-like carbon film having a sp3 carbon bonding that is greater than 60 percent and a density greater than 2.4 grams per cm³, for which the diamond-like carbon film is deposited by a high-voltage magnetron sputtering tool with an enhanced power source.

Example 20 may include the etch mask of example 19 and/or any other example disclosed herein, which further includes the diamond-like carbon film having a sp3 carbon bonding that is greater than approximately 75 percent and a composition of hydrogen of approximately 0 percent.

The term "comprising" shall be understood to have a broad meaning similar to the term "including" and will be understood to imply the inclusion of a stated integer or operation or group of integers or operations but not the exclusion of any other integer or operation or group of integers or operations. This definition also applies to variations on the term "comprising" such as "comprise" and "comprises".

The term "coupled" (or "connected") herein may be understood as electrically coupled or as mechanically coupled, e.g., attached or fixed or attached, or just in contact without any fixation, and it will be understood that both direct coupling or indirect coupling (in other words: coupling without direct contact) may be provided.

The terms "and" and "or" herein may be understood to mean "and/or" as including either or both of two stated possibilities.

While the present disclosure has been particularly shown and described with reference to specific aspects, it should be understood by those skilled in the art that various changes in form and detail may be made therein without departing from the spirit and scope of the present disclosure as defined by the appended claims. The scope of the present disclosure is thus indicated by the appended claims and all changes which come within the meaning and range of equivalency of the claims are therefore intended to be embraced.

## Claims

1. A semiconductor tool comprising:
a vacuum chamber;
a magnetron cathode comprising a magnet array;
a target disposed near the magnetron cathode;
an anode, wherein the magnetron cathode, the target, and the anode are disposed within the vacuum chamber;
an enhanced power source that is coupled to the magnetron cathode; and
a second power source that is coupled to the anode.

2. The semiconductor tool of claim 1, wherein the enhanced power source comprises a standard power source and a supplemental high-power DC power source with a controller that produces a pulsed output.

3. The semiconductor tool of any one of claims 1 or 2, wherein the enhanced power source comprises a high-power DC power source with a controller that produces a pulsed output.

4. The semiconductor tool of any one of claims 1 to 3, wherein the second power source comprises an RF power source or a high-power DC power source with a controller that produces a pulsed output.

5. The semiconductor tool of any one of claims 1 to 4, wherein the enhanced power source provides a voltage output in a range of approximately 6 to 15 kilowatts.

6. The semiconductor tool of any one of claims 1 to 5, wherein the enhanced power source provides a peak current in a range of approximately 400 to 2000 amps.

7. The semiconductor tool of any one of claims 5 or 6, wherein the enhanced power source provides a peak current density in a range of approximately 0.5 to 1A per cm².

8. The semiconductor tool of any one of claims 1 to 7, wherein the enhanced power source provides output pulses having a pulse frequency in a range of approximately 10 to 100 kHz.

9. The semiconductor tool of any one of claims 7 or 8, wherein the enhanced power source provides output pulses having a high current pulse duration in a range of approximately 10 to 100 µs.

10. The semiconductor tool of any one of claims 1 to 9, wherein the target comprises a carbon material.

11. The semiconductor tool of any one of claims 1 to 10, wherein the anode comprises a support or chuck for a semiconductor wafer.

12. A method comprising:
providing a substrate;
providing a high-voltage magnetron sputtering tool comprising an enhanced power source;
providing a carbon target; and
setting operating conditions to deposit a hydrogen-free diamond-like carbon film on the substrate.

13. The method of claim 12, wherein the operating conditions comprise an operating temperature in a range of approximately 20 to 150 C°; and/or
wherein the operating conditions comprise the enhanced power source providing a voltage output in a range of approximately 6 to 15 kilowatts.

14. The method of any one of claims 12 or 13, wherein the operating conditions comprise the enhanced power source providing a peak current in a range of approximately 400 to 2000 amps;
preferably wherein the operating conditions comprise the enhanced power source providing a peak current density in a range of approximately 0.5 to 1A per cm².

15. The method of any one of claims 12 to 14, wherein the operating conditions comprise the enhanced power source providing a pulse frequency in a range of approximately 10 to 100 kHz;
preferably wherein the operating conditions comprise the enhanced power source providing a high current pulse duration in a range of approximately 10 to 100 µs.
